(19) **Europäisches Patentamt / European Patent Office / Office européen des brevets**

(11) **EP 3 503 174 B1**

(12) **FASCICULE DE BREVET EUROPEEN**

(45) Date de publication et mention
de la délivrance du brevet:
**15.04.2020 Bulletin 2020/16**

(51) Int Cl.:
***H01L 21/762*** *(2006.01)*

(21) Numéro de dépôt: **18213103.7**

(22) Date de dépôt: **17.12.2018**

(54) **PROCEDE DE TRANSFERT D'UNE COUCHE UTILE**

ÜBERTRAGUNGSVERFAHREN EINER NUTZSCHICHT

USEFUL FILM TRANSFER METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2017 FR 1762975**

(43) Date de publication de la demande:
**26.06.2019 Bulletin 2019/26**

(73) Titulaire: **Commissariat à l'Energie Atomique et aux Energies Alternatives
75015 Paris (FR)**

(72) Inventeurs:
- **MORICEAU, Hubert
  38120 SAINT-EGREVE (FR)**
- **MORALES, Christophe
  38220 SAINT PIERRE DE MESAGE (FR)**

(74) Mandataire: **GIE Innovation Competence Group
310, avenue Berthelot
69372 Lyon Cedex 08 (FR)**

(56) Documents cités:
**US-A1- 2011 014 775     US-A1- 2011 086 492
US-A1- 2013 309 843**

## Description

### Domaine technique

L'invention se rapporte au domaine technique du transfert d'une couche utile sur un substrat support par la technologie Smart Cut™.

L'invention trouve notamment son application dans la fabrication de substrats de type silicium sur isolant SOI («*Silicon-On-Insulator*» en langue anglaise).

### Etat de la technique antérieure

Un procédé de transfert d'une couche utile sur un substrat support, connu de l'état de la technique, comporte les étapes successives :

a') prévoir un substrat donneur comprenant une première surface ;

b') former un premier film diélectrique sur la première surface du substrat donneur ;

c') implanter des espèces gazeuses dans le substrat donneur, à travers le premier film diélectrique, de manière à former une zone de fragilisation, la couche utile étant délimitée par la zone de fragilisation et par la première surface du substrat donneur ;

d') assembler le substrat donneur au substrat support par une adhésion directe avec le premier film diélectrique ;

e') fracturer le substrat donneur suivant la zone de fragilisation de manière à exposer la couche utile.

Classiquement, le substrat donneur peut être réalisé en silicium et le premier film diélectrique peut être réalisé en $SiO_2$. Un tel procédé de l'état de la technique n'est pas entièrement satisfaisant dans la mesure où des défauts sont susceptibles d'apparaître après l'étape e') de fracturation (« *splitting* » en langue anglaise), en particulier à partir de l'interface de collage entre le substrat donneur et le substrat support. On peut citer comme défauts des zones non-transférées ou encore des zones bullées. Ces défauts sont d'autant plus nombreux que le premier film diélectrique est fin, c'est-à-dire avec une épaisseur comprise entre 1 nm et 5 nm. Le document US2011/086492 décrit un tel procédé.

### Exposé de l'invention

L'invention vise à remédier en tout ou partie aux inconvénients précités. A cet effet, l'invention a pour objet un procédé de transfert d'une couche utile sur un substrat support, comportant les étapes successives :

a) prévoir un substrat donneur comprenant une première surface ;

b) lisser la première surface du substrat donneur jusqu'à l'obtention d'une topologie de surface reconstruite jusqu'à l'obtention d'une topologie de surface reconstruite comprenant une succession de plans atomiques présentant une orientation cristalline principale (vecteur o) formant un angle ($\alpha$) de désorientation inférieur à 5° avec la normale (vecteur n) à la surface moyenne ($S_{moy}$);

c) former un premier film diélectrique sur la première surface lissée du substrat donneur, de sorte que le premier film diélectrique présente une surface conservant la topologie de surface reconstruite ;

d) implanter des espèces gazeuses dans le substrat donneur, à travers le premier film diélectrique, de manière à former une zone de fragilisation, la couche utile étant délimitée par la zone de fragilisation et par la première surface du substrat donneur ;

e) assembler le substrat donneur au substrat support par une adhésion directe ;

f) fracturer le substrat donneur suivant la zone de fragilisation de manière à exposer la couche utile.

Un tel procédé selon l'invention permet de réduire significativement les défauts susceptibles d'apparaître à l'interface de collage après l'étape f), et ce grâce aux étapes b) et c). En effet, le lissage exécuté lors de l'étape b) permet de reconstruire la première surface du substrat donneur en réduisant au minimum sa rugosité de surface, à savoir jusqu'à la présence observable de marches à l'échelle atomique (par exemple à l'aide d'un microscope à force atomique). Cette rugosité de surface, réduite au minimum, est conservée à la surface du premier film diélectrique lors de l'étape c), et le cas échéant également lors de l'étape e) de collage, dès lors que l'étape d) d'implantation n'a pas modifié substantiellement la nature du premier film diélectrique.

Les inventeurs ont donc constaté un lien de causalité entre une forte rugosité de surface et un nombre important de défauts à l'interface de collage (e.g. zones de poches de liquide voire de gaz), le lien de causalité étant d'autant plus marqué que le premier film diélectrique est fin (par exemple présentant une épaisseur comprise entre 1 nm et 5 nm).

Définitions

- Par « couche utile», on entend une couche à partir de laquelle peut être formé un dispositif pour tout type d'applications, notamment électronique, mécanique, optique etc.
- Par « topologie de surface reconstruite », on entend un réseau de plans atomiques (appelés terrasses ; en anglais « *vicinal planes* ») séparés entre eux par des marches (pouvant être monoatomiques ou multi-atomiques). La surface reconstruite comprend donc une succession de plans atomiques présentant une orientation cristalline principale quasiment parallèle à la normale à la surface moyenne (ou surface nominale plane), c'est-à-dire que l'orientation cris-

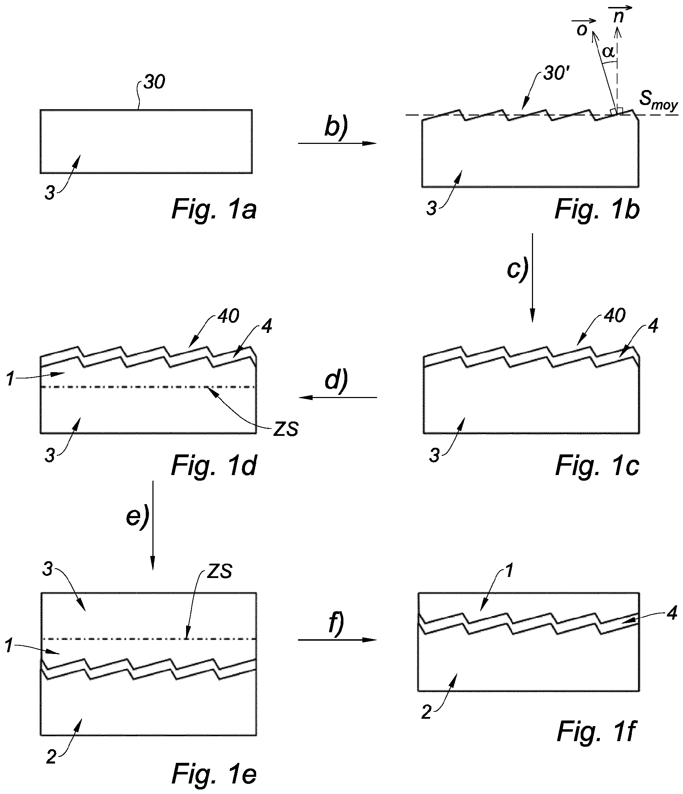

talline principale ($\vec{o}$) des plans atomiques et la normale ($\vec{n}$) à la surface moyenne ($S_{moy}$) forment un angle $\alpha$ (appelé angle de désorientation, cf. figure 1b) inférieur à 5°, voire inférieur à 3°.

- Par « adhésion directe », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire.

Le procédé selon l'invention peut comporter une ou plusieurs des caractéristiques suivantes.

Selon une caractéristique de l'invention, l'étape e) est exécutée de sorte que l'adhésion directe s'opère avec la surface du premier film diélectrique.

Ainsi, le premier film diélectrique assure la fonction d'oxyde enterré (BOX pour « *Burried OXide* » en langue anglaise) dans le cas de la fabrication d'un substrat de type SOI. Une telle étape e) convient lorsque l'étape d) d'implantation n'a pas modifié substantiellement la nature du premier film diélectrique.

Selon une caractéristique de l'invention, l'étape d) introduit des modifications sous la surface du premier film diélectrique ; le procédé comportant une étape $d_0$) consistant à traiter le premier film diélectrique de manière à corriger lesdites modifications, l'étape $d_0$) étant exécutée après l'étape d) et avant l'étape e).

Ainsi, un avantage procuré est de pouvoir utiliser le premier film diélectrique comme BOX lorsque l'étape d) d'implantation a modifié substantiellement la nature du premier film diélectrique.

Selon une caractéristique de l'invention, l'étape $d_0$) est exécutée en appliquant un rayonnement ultraviolet à la surface du premier film diélectrique, sous une atmosphère d'ozone, à une température comprise entre 20°C et 500°C, préférentiellement comprise entre 20°C et 400°C, plus préférentiellement comprise entre 20°C et 300°C.

Ainsi, un avantage procuré est de pouvoir assurer la présence d'un film diélectrique de bonne qualité, compatible avec l'application visée. Les inventeurs ont constaté que des températures supérieures à 500°C ne permettent pas de réduire la rugosité de surface du premier film diélectrique. C'est pourquoi une oxydation thermique (par exemple exécutée à 900°C pour le $SiO_2$) ne convient pas pour l'obtention d'une topologie de surface reconstruite. En outre, un tel traitement UV-ozone permet d'obtenir un oxyde permettant un collage présentant moins de défauts qu'avec une oxydation thermique.

Selon une caractéristique de l'invention, le procédé comporte les étapes successives :

- $d_1$) retirer le premier film diélectrique après l'étape d) et avant l'étape e) ;
- $d_2$) former un deuxième film diélectrique sur la première surface lissée du substrat donneur, de sorte que le deuxième film diélectrique présente une surface conservant la topologie de surface reconstruite ;

l'étape e) étant exécutée de sorte que l'adhésion directe s'opère avec la surface du deuxième film diélectrique.

Ainsi, un avantage procuré est de s'affranchir d'un traitement ad hoc du premier film diélectrique lorsque l'étape d) d'implantation a modifié substantiellement la nature du premier film diélectrique. Le deuxième film diélectrique assure ici la fonction de BOX dans le cas de la fabrication d'un substrat de type SOI.

Selon une caractéristique de l'invention, l'étape b) est exécutée par un traitement thermique sous une atmosphère comportant des espèces hydrogénées, lorsque le substrat donneur est réalisé dans un matériau sélectionné parmi Si, Ge, $Si_xGe_y$.

Ainsi, un avantage procuré est de pouvoir obtenir aisément une topologie de surface reconstruite à la première surface du substrat donneur, tout particulièrement lorsque le substrat donneur est réalisé en silicium, germanium, ou un alliage Si-Ge. Un tel traitement peut également convenir pour certains matériaux III-V.

Selon une caractéristique de l'invention, l'étape c) est exécutée par une oxydation de la première surface du substrat donneur en appliquant un rayonnement ultraviolet, sous une atmosphère d'ozone, à une température comprise entre 20°C et 500°C, préférentiellement comprise entre 20°C et 400°C, plus préférentiellement comprise entre 20°C et 300°C.

Ainsi, un avantage procuré par une telle oxydation est de pouvoir obtenir aisément une topologie de surface reconstruite à la surface du premier film diélectrique. Les inventeurs ont constaté que des températures supérieures à 500°C ne permettent pas de réduire la rugosité de surface du premier film diélectrique. C'est pourquoi une oxydation thermique (par exemple exécutée à 900°C pour le $SiO_2$) ne convient pas pour l'obtention d'une topologie de surface reconstruite.

Selon une caractéristique de l'invention, l'étape c) est exécutée par un dépôt ALD du premier film diélectrique.

ALD est l'acronyme pour « *Atomic Layer Deposition* » en langue anglaise.

Ainsi, un avantage procuré est l'obtention d'un dépôt conforme, permettant de conserver la topologie de surface reconstruite de la première surface du substrat donneur.

Selon une caractéristique de l'invention, le procédé comporte une étape consistant à lisser une première surface du substrat support jusqu'à l'obtention d'une topologie de surface reconstruite ; l'étape e) étant exécutée de sorte que l'adhésion directe s'opère avec la première surface lissée du substrat support.

Ainsi, un avantage procuré par le lissage du substrat support est de réduire fortement le nombre de défauts susceptibles d'apparaître à l'interface de collage après l'étape f). De même qu'évoqué précédemment, un tel lissage de la première surface du substrat support permet de réduire au minimum sa rugosité de surface, à savoir jusqu'à la présence observable de marches à l'échelle atomique (par exemple à l'aide d'un microscope à force atomique), en vue de l'étape e) de collage.

Selon une caractéristique de l'invention, le procédé comporte les étapes :

- lisser une première surface du substrat support jusqu'à l'obtention d'une topologie de surface reconstruite ;
- former un film diélectrique additionnel sur la première surface lissée du substrat support, de sorte que le film diélectrique additionnel présente une surface conservant la topologie de surface reconstruite ;

l'étape e) étant exécutée de sorte que l'adhésion directe s'opère avec la surface du film diélectrique additionnel.

Ainsi, la rugosité de surface du film diélectrique additionnel est réduite au minimum, à savoir jusqu'à la présence observable de marches à l'échelle atomique (par exemple à l'aide d'un microscope à force atomique), en vue de l'étape e) de collage. Par ailleurs, le film diélectrique additionnel contribue à assurer la fonction de BOX dans le cas de la fabrication d'un substrat de type SOI.

Selon une caractéristique de l'invention, le premier film diélectrique et le film diélectrique additionnel présentent une épaisseur totale inférieure ou égale à 30 nm, préférentiellement inférieure ou égale à 20 nm, plus préférentiellement inférieure ou égale à 10 nm.

Par « épaisseur totale », on entend la somme de l'épaisseur du premier film diélectrique et de l'épaisseur du film diélectrique additionnel.

Ainsi, un avantage procuré est l'obtention d'un BOX ultra fin dans le cas de la fabrication d'un substrat de type SOI.

Selon une caractéristique de l'invention, le premier film diélectrique formé lors de l'étape c) présente une épaisseur comprise entre 0,2 nm et 5 nm ou comprise entre 0,5 nm et 5 nm.

Ainsi, un avantage procuré est l'obtention d'un BOX ultra fin dans le cas de la fabrication d'un substrat de type SOI.

Selon une caractéristique de l'invention, le substrat donneur est réalisé dans un matériau semi-conducteur, de préférence sélectionné dans le groupe comportant Si, Ge, Si-Ge, un matériau III-V.

- Par « semi-conducteur », on entend que le matériau présente une conductivité électrique à 300 K comprise entre $10^{-8}$ S/cm et $10^3$ S/cm.
- Par « matériau III-V », on entend un alliage binaire entre des éléments situés respectivement dans la colonne III et dans la colonne V du tableau périodique des éléments.

Selon une caractéristique de l'invention, le procédé comporte une étape $e_1$) consistant à appliquer un traitement thermique à l'assemblage obtenu lors de l'étape e) selon un budget thermique adapté pour renforcer l'adhésion directe sans initier la fracture du substrat donneur suivant la zone de fragilisation ; l'étape $e_1$) étant exécutée avant l'étape f).

Par « budget thermique », on entend le choix d'une valeur de température et d'une valeur de durée du traitement thermique.

Ainsi, un avantage procuré est un renforcement de l'adhésion directe en termes d'adhérence permettant de réduire la taille de défauts susceptibles d'apparaître à l'interface de collage.

**Brève description des dessins**

D'autres caractéristiques et avantages apparaîtront dans l'exposé détaillé de différents modes de réalisation de l'invention, l'exposé étant assorti d'exemples et de références aux dessins joints.

Figures la à 1f sont des vues schématiques en coupe illustrant un premier mode de mise en œuvre d'un procédé selon l'invention.

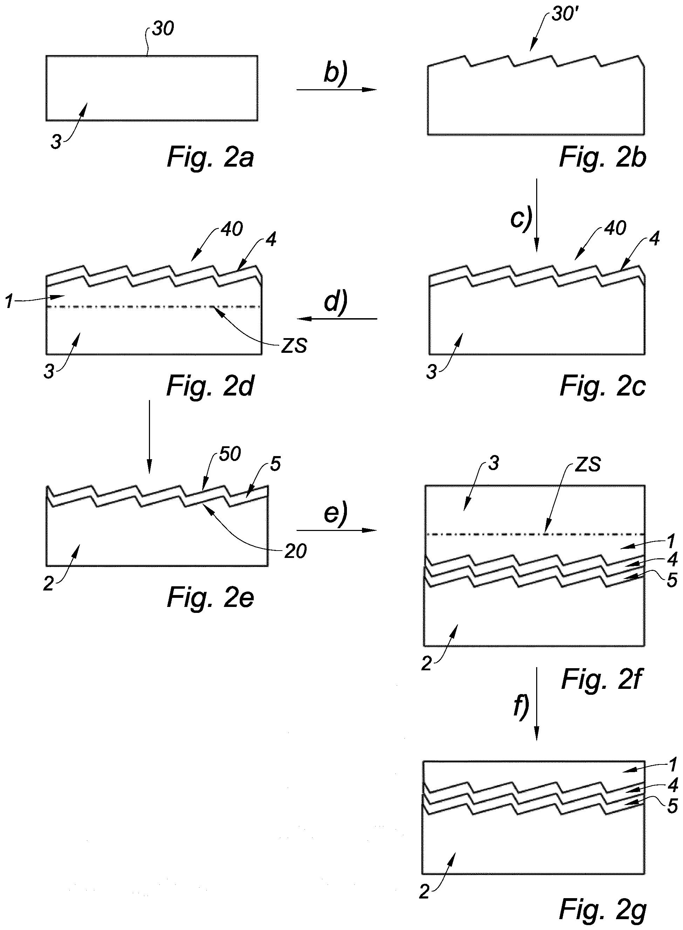

Figures 2a à 2g sont des vues schématiques en coupe illustrant un deuxième mode de mise en œuvre d'un procédé selon l'invention.

Les figures ne sont pas représentées à l'échelle pour en simplifier leur compréhension.

**Exposé détaillé des modes de réalisation**

Les éléments identiques ou assurant la même fonction porteront les mêmes références pour les différents modes de réalisation, par souci de simplification.

Un objet de l'invention est un procédé de transfert d'une couche utile 1 sur un substrat support 2, comportant les étapes successives :

a) prévoir un substrat donneur 3 comprenant une première surface 30 ;
b) lisser la première surface 30 du substrat donneur 3 jusqu'à l'obtention d'une topologie de surface reconstruite ;
c) former un premier film diélectrique 4 sur la première surface lissée 30' du substrat donneur 3, de sorte que le premier film diélectrique 4 présente une surface 40 conservant la topologie de surface reconstruite ;
d) implanter des espèces gazeuses dans le substrat donneur 3, à travers le premier film diélectrique 4, de manière à former une zone de fragilisation ZS, la couche utile 1 étant délimitée par la zone de fragilisation ZS et par la première surface 30 du substrat donneur 3 ;

e) assembler le substrat donneur 3 au substrat support 2 par une adhésion directe ;

f) fracturer le substrat donneur 3 suivant la zone de fragilisation ZS de manière à exposer la couche utile 1.

L'étape a) est illustrée aux figures 1a et 2a. L'étape b) est illustrée aux figures 1b et 2b. L'étape c) est illustrée aux figures 1c et 2c. L'étape d) est illustrée aux figures 1d et 2d. L'étape e) est illustrée aux figures 1e et 2f. Enfin, l'étape f) est illustrée aux figures 1f et 2g.

## Substrat donneur

Le substrat donneur 3 est avantageusement réalisé dans un matériau semi-conducteur, de préférence sélectionné dans le groupe comportant Si, Ge, Si-Ge, un matériau III-V.

L'étape b) est avantageusement exécutée par un traitement thermique sous une atmosphère comportant des espèces hydrogénées (par exemple une atmosphère d'hydrogène), lorsque le substrat donneur 3 est réalisé dans un matériau sélectionné parmi Si, Ge, $Si_xGe_y$. De manière générale, l'étape b) est exécutée par un traitement thermique sous une atmosphère adaptée au matériau à reconstruire. A titre d'exemple non limitatif, lorsque le substrat donneur 3 est réalisé en silicium avec une première surface 30 de type (1, 0, 0), le traitement thermique peut s'effectuer sous hydrogène à 1100°C pendant environ 1 minute. La topologie de surface reconstruite obtenue à l'issue de l'étape b) comporte un réseau de terrasses planes à l'échelle atomique séparées par des marches majoritairement monoatomiques (éventuellement multi-atomiques). Plus précisément, pour une première surface 30 de type (1, 0, 0), la topologie de surface reconstruite comporte une alternance de bords de marche (de forme droite) et de bords en forme de méandres correspondant à l'alternance d'orientation des dimères Si-H d'une marche à la marche suivante. Cette reconstruction de surface est connue de l'état de la technique, notamment des documents :

- M. Kolmer et al., « Atomic scale fabrication of dangling bond structures on hydrogen passivated Si (0 0 1) wafers processed and nanopackaged in a clean room environment », Appl. Surf. Sci., 288, 83-89, 2014 ;
- V. Loup et al., « Reduced pressure chemical vapour deposition of Si/Si1-x-yGexCy heterostructures using a chlorinated chemistry », Semicond. Sci. Technol., 18, 352-360, 2003.

Pour d'autres matériaux tels que Ge, Si-Ge, un matériau III-V, l'homme du métier saura adapter les conditions de pression partielle et/ou de concentration d'hydrogène pour permettre un lissage efficace de la première surface 30 du substrat donneur 3.

## Premier film diélectrique

L'étape c) est avantageusement exécutée par une oxydation de la première surface 30 du substrat donneur 3 en appliquant un rayonnement ultraviolet, sous une atmosphère d'ozone, à une température comprise entre 20°C et 500°C, préférentiellement comprise entre 20°C et 400°C, plus préférentiellement comprise entre 20°C et 300°C. Un tel traitement UV-ozone est appliqué préférentiellement pendant une durée comprise entre 5 minutes et 10 minutes. A titre d'exemple non limitatif, lorsque le substrat donneur 3 est réalisé en silicium, et lorsque le premier film diélectrique 4 est un film d'oxyde en $SiO_2$, une telle oxydation radicalaire permet d'observer la topologie de surface reconstruite à la surface du film d'oxyde, par exemple par microscopie à force atomique.

Selon une alternative, l'étape c) est exécutée par un dépôt ALD du premier film diélectrique 4. A titre d'exemple non limitatif, le premier film diélectrique 4 peut être réalisé en $Al_2O_3$.

Le premier film diélectrique 4 formé lors de l'étape c) présente avantageusement une épaisseur comprise entre 0,2 nm et 5 nm ou comprise entre 0,5 nm et 5 nm.

Lorsque l'étape d) introduit des modifications sous la surface 40 du premier film diélectrique 4, le procédé peut comporter une étape $d_0$) consistant à traiter le premier film diélectrique 4 de manière à corriger lesdites modifications, l'étape $d_0$) étant exécutée après l'étape d) et avant l'étape e). L'étape $d_0$) est avantageusement exécutée en appliquant un rayonnement ultraviolet à la surface 40 du premier film diélectrique 4, sous une atmosphère d'ozone, à une température comprise entre 20°C et 500°C, préférentiellement comprise entre 20°C et 400°C, plus préférentiellement comprise entre 20°C et 300°C. Le budget thermique de l'étape $d_0$) est choisi de manière à ne pas fragiliser excessivement la zone de fragilisation ZS avant l'étape e) de collage (e.g. bullage, exfoliation). Par conséquent, un tel traitement UV-ozone est appliqué par exemple pendant une durée comprise entre 5 minutes et 10 minutes.

Selon une alternative, le procédé peut comporter les étapes successives :

- $d_1$) retirer le premier film diélectrique 4 après l'étape d) et avant l'étape e) ;
- $d_2$) former un deuxième film diélectrique sur la première surface lissée 30' du substrat donneur 3, de sorte que le deuxième film diélectrique présente une surface conservant la topologie de surface reconstruite.

Les inventeurs ont constaté que l'étape $d_1$) de retrait du premier film diélectrique 4 n'affectait pas la topologie de surface reconstruite à la première surface 30 du substrat donneur 3. Lorsque le premier film diélectrique 4 est réalisé en $SiO_2$, l'étape $d_1$) peut être exécutée à l'aide d'une solution d'acide fluorhydrique.

L'étape d$_2$) est avantageusement exécutée par une oxydation de la première surface 30 du substrat donneur 3 en appliquant un rayonnement ultraviolet, sous une atmosphère d'ozone, à une température comprise entre 20°C et 500°C, préférentiellement comprise entre 20°C et 400°C, plus préférentiellement comprise entre 20°C et 300°C. Un tel traitement UV-ozone est appliqué préférentiellement pendant une durée comprise entre 5 minutes et 10 minutes. Comme évoqué précédemment, le budget thermique du traitement UV-ozone est choisi de manière à ne pas fragiliser excessivement la zone de fragilisation ZS avant l'étape e) de collage (e.g. bullage, exfoliation).

Selon une alternative, l'étape d$_2$) peut être exécutée par un dépôt ALD du deuxième film diélectrique, ou par toute autre technique de dépôt à basse température n'affectant pas la topologie de surface du substrat donneur 3.

Substrat support

Le procédé comporte avantageusement une étape consistant à lisser une première surface 20 du substrat support 2 jusqu'à l'obtention d'une topologie de surface reconstruite.

Selon un mode de mise en œuvre illustrée à la figure 2e, le procédé peut comporter les étapes :

- lisser une première surface 20 du substrat support 2 jusqu'à l'obtention d'une topologie de surface reconstruite ;
- former un film diélectrique additionnel 5 sur la première surface 20 lissée du substrat support 2, de sorte que le film diélectrique additionnel 5 présente une surface 50 conservant la topologie de surface reconstruite.

Le lissage de la première surface 20 du substrat support 2 est avantageusement exécuté par un traitement thermique sous une atmosphère d'hydrogène. A titre d'exemple non limitatif, lorsque le substrat support 2 est réalisé en silicium avec une première surface 20 de type (1, 0, 0), le traitement thermique peut s'effectuer à 1100°C pendant environ 1 minute.

La formation du film diélectrique additionnel 5 est avantageusement exécutée par une oxydation de la première surface 20 du substrat support 2 en appliquant un rayonnement ultraviolet, sous une atmosphère d'ozone, à une température comprise entre 20°C et 500°C, préférentiellement comprise entre 20°C et 400°C, plus préférentiellement comprise entre 20°C et 300°C. Un tel traitement UV-ozone est appliqué par exemple pendant une durée comprise entre 5 minutes et 10 minutes. Le film diélectrique additionnel 5 peut être formé par d'autres techniques, notamment par ALD, ce qui permet d'obtenir des épaisseurs plus élevées qu'avec un traitement UV-ozone.

Le premier film diélectrique 4 et le film diélectrique additionnel 5 présentent avantageusement une épaisseur totale inférieure ou égale à 30 nm, préférentiellement inférieure ou égale à 20 nm, plus préférentiellement inférieure ou égale à 10 nm.

Etape d) d'implantation

Les espèces gazeuses implantées lors de l'étape d) comportent préférentiellement des atomes d'hydrogène ionisé.

Il est également possible d'effectuer une co-implantation avec d'autres espèces gazeuses (e.g. l'hélium), ou encore d'effectuer une multi-implantation des mêmes espèces gazeuses.

A titre d'exemple non limitatif, lorsque le substrat donneur 3 est réalisé en silicium, l'étape d) peut être exécutée avec des atomes d'hydrogène ionisé selon les paramètres suivants :

- une énergie de 85 keV,
- une dose de $5 \times 10^{16}$ at.cm$^{-2}$.

Etape e) de collage

Lorsque l'étape d) d'implantation n'a pas modifié substantiellement la nature du premier film diélectrique 4, l'étape e) peut être exécutée de sorte que l'adhésion directe s'opère avec la surface 40 du premier film diélectrique 4.

Lorsque le procédé met en œuvre les étapes d$_1$) et d$_2$), l'étape e) est exécutée de sorte que l'adhésion directe s'opère avec la surface du deuxième film diélectrique.

Lorsque la première surface 20 du substrat support 2 est lissée, l'étape e) est exécutée de sorte que l'adhésion directe s'opère avec la première surface 20 lissée du substrat support 2.

En présence d'un film diélectrique additionnel 5, l'étape e) est exécutée de sorte que l'adhésion directe s'opère avec la surface 50 du film diélectrique additionnel 5.

L'étape e) de collage peut être précédée d'étapes consistant à nettoyer ou préparer les surfaces à coller, par exemple pour éviter la contamination des surfaces par des hydrocarbures, des particules, ou des éléments métalliques. A titre d'exemple non limitatif, il est possible de traiter les surfaces à coller à l'aide d'une solution diluée SC1 (mélange de $NH_4OH$ et de $H_2O_2$) afin de provoquer des liaisons chimiques de surface aptes à réaliser une bonne adhésion. Ces étapes de nettoyage ou de préparation des surfaces à coller peuvent nécessiter l'application d'un budget thermique qui doit rester suffisamment faible pour ne pas initier la fracture du substrat donneur 3 suivant la zone de fragilisation ZS, et ne pas déformer les surfaces à coller (les rendant incompatibles avec le collage direct subséquent). On se limitera à un budget thermique inférieur à 10% du budget thermique de fracture. Par « budget thermique », on entend le choix d'une valeur de température et d'une valeur de durée du traitement thermique. Par « budget thermique de fracture », on entend le budget thermique total à appliquer après l'étape d) pour obtenir la fracture à l'issue de l'étape f). On peut définir un pourcentage du budget thermique de fracture. Le budget thermique de fracture peut être décrit par une loi de type Arrhenius permettant de relier le temps de la fracture (noté t) à la température du traitement thermique (notée T, en K) :

$$t = A\ exp\left(-E_a\big/_{kT}\right)$$

où :

- A est une constante,
- $E_a$ est une constante correspondant à l'énergie d'activation du mécanisme impliqué dans le transfert,
- k est la constante de Boltzmann.

$E_a$ peut être déterminée expérimentalement à partir de 2 points de fonctionnement : il s'agit de la pente de la droite log(t) en fonction de 1/kT.

$E_a$ étant connue, on détermine facilement pour une température $T_1$ donnée, le temps $t_1$ nécessaire à l'obtention de la fracture. Par convention, on dira que le pourcentage du budget thermique utilisé correspond au pourcentage du temps $t_1$ passé à la température $T_1$. Ainsi, par exemple, pour rester à moins de 10% du budget thermique de fracture, on choisira une durée t inférieure à $t_1/10$ pour un traitement thermique à une température $T_1$.

A titre d'exemples non limitatifs, ces étapes de nettoyage ou de préparation des surfaces à coller peuvent être exécutées par un traitement plasma ou par pulvérisation par faisceau d'ions (IBS pour « *Ion Beam Sputtering* » en langue anglaise).

L'étape e) est préférentiellement exécutée dans un milieu à atmosphère contrôlée. A titre d'exemple non limitatif, l'étape e) peut être exécutée sous vide poussé tel qu'un vide secondaire inférieur à $10^{-2}$ mbar. L'étape e) peut être assistée par un bombardement ionique ou par un plasma.

## Etape f) de fracture

L'étape f) de fracture (« *splitting* » en langue anglaise) est avantageusement exécutée par un traitement thermique selon un budget thermique adapté.

## Renforcement de l'interface de collage

Le procédé comporte avantageusement une étape e₁) consistant à appliquer un traitement thermique à l'assemblage obtenu lors de l'étape e) selon un budget thermique adapté pour renforcer l'adhésion directe sans initier la fracture du substrat donneur 3 suivant la zone de fragilisation ZS ; l'étape e₁) étant exécutée avant l'étape f).

Le budget thermique de l'étape e₁) est avantageusement choisie pour ne pas dépasser 10% du budget thermique de fracture. A titre d'exemple non limitatif, la température peut être de l'ordre de 300°C pour une durée de l'ordre d'une heure.

Le procédé comporte avantageusement une étape g) consistant à appliquer un traitement thermique à l'assemblage obtenu à l'issue de l'étape f), selon un budget thermique adapté pour renforcer l'adhésion directe entre la couche utile 1 et le substrat support 2.

## Exemple de réalisation n°1

Le substrat donneur 3 est un substrat de silicium nettoyé avec des solutions de SC1 et SC2, rincé à l'eau déionisée, puis à l'aide d'une solution de HF.

L'étape b) est exécutée par un traitement thermique du substrat donneur 3, à 1100°C, sous une atmosphère d'hydrogène, pendant 10 minutes, de manière à lisser la première surface 30 du substrat donneur 3 jusqu'à l'obtention d'une topologie de surface reconstruite.

L'étape c) est exécutée par un traitement UV-ozone, pendant une heure, à température ambiante, par exemple dans un bâti de type « *UV Ozone Cleaner* » de la société SAMCO. L'étape c) est exécutée en injectant un flux d'ozone permettant de former le premier film diélectrique 4 de $SiO_2$, avec une épaisseur de 1,5 nm.

L'étape d) est exécutée avec des atomes d'hydrogène ionisé selon les paramètres suivants :

- une énergie de 85 keV,
- une dose de $5\times10^{16}$ at.cm$^{-2}$.

L'étape d₁) est exécutée en éliminant le premier film diélectrique 4 à l'aide d'une solution de HF.

L'étape d₂) est exécutée en formant le deuxième film diélectrique, d'une épaisseur de 1,6 nm, par un traitement UV-ozone à 300°C pendant 8 minutes.

La première surface 20 du substrat support 2 (en silicium) est lissée jusqu'à l'obtention d'une topologie de surface reconstruite, et ce par un traitement thermique du substrat support 2, à 1100°C, sous une atmosphère d'hydrogène, pendant 3 minutes.

Le film diélectrique additionnel 5 est formé à la première surface 20 lissée du substrat support 2 par un traitement UV-ozone à 300°C pendant 1 heure.

Après l'étape e) de collage, l'étape e₁) est exécutée par un traitement thermique à 300°C pendant 1 heure.

L'étape f) est exécutée par un traitement thermique à 400°C pendant 5 heures.

## Exemple de réalisation n°2

Le substrat donneur 3 est un substrat de silicium nettoyé avec des solutions de SC1 et SC2, rincé à l'eau déionisée, puis à l'aide d'une solution de HF.

L'étape b) est exécutée par un traitement thermique du substrat donneur 3, à 1100°C, sous une atmosphère d'hydrogène, pendant 10 minutes, de manière à lisser la première surface 30 du substrat donneur 3 jusqu'à l'obtention d'une topologie de surface reconstruite.

L'étape c) est exécutée par un traitement UV-ozone, à 300°C, pendant 1 heure, par exemple dans un bâti de type « *UV Ozone Cleaner* » de la société SAMCO. L'étape c) est exécutée en injectant un flux d'ozone permettant de former le premier film diélectrique 4 de $SiO_2$, avec une épaisseur de 2 nm.

L'étape d) est exécutée avec des atomes d'hydrogène ionisé selon les paramètres suivants :

- une énergie de 85 keV,
- une dose de $6 \times 10^{16}$ at.cm$^{-2}$.

Le premier film diélectrique 4 est nettoyé avec des solutions de SC1 et SC2 afin d'assurer une bonne hydrophilie de surface et supprimer les contaminants laissés lors de l'étape d). L'étape $d_0$) est exécutée par un traitement UV-ozone à 300°C pendant 8 minutes afin de guérir le premier film diélectrique 4, c'est-à-dire supprimer les endommagements occasionnés lors de l'étape d).

La première surface 20 du substrat support 2 (en silicium) est lissée jusqu'à l'obtention d'une topologie de surface reconstruite, et ce par un traitement thermique du substrat support 2, à 1100°C, sous une atmosphère d'hydrogène, pendant 3 minutes.

Le film diélectrique additionnel 5 est formé à la première surface 20 lissée du substrat support 2 par un traitement UV-ozone à 300°C pendant 1 heure.

Après l'étape e) de collage, l'étape $e_1$) est exécutée par un traitement thermique à 300°C pendant 1 heure.

L'étape f) est exécutée par un traitement thermique à 400°C pendant 3 heures.

## Revendications

**1.** Procédé de transfert d'une couche utile (1) sur un substrat support (2), comportant les étapes successives :

     a) prévoir un substrat donneur (3) comprenant une première surface (30) ;
     b) lisser la première surface (30) du substrat donneur (3) jusqu'à l'obtention d'une topologie de surface reconstruite comprenant une succession de plans atomiques présentant une orientation cristalline principale ($\vec{o}$) formant un angle ($\alpha$) de désorientation inférieur à 5° avec la normale ($\vec{n}$) à la surface moyenne ($S_{moy}$) ;
     c) former un premier film diélectrique (4) sur la première surface lissée (30') du substrat donneur (3), de sorte que le premier film diélectrique (4) présente une surface (40) conservant la topologie de surface reconstruite ;
     d) implanter des espèces gazeuses dans le substrat donneur (3), à travers le premier film diélectrique (4), de manière à former une zone de fragilisation (ZS), la couche utile (1) étant délimitée par la zone de fragilisation (ZS) et par la première surface (30) du substrat donneur (3) ;
     e) assembler le substrat donneur (3) au substrat support (2) par une adhésion directe ;
     f) fracturer le substrat donneur (3) suivant la zone de fragilisation (ZS) de manière à exposer la couche utile (1).

**2.** Procédé selon la revendication 1, dans lequel l'étape e) est exécutée de sorte que l'adhésion directe s'opère avec la surface (40) du premier film diélectrique (4).

**3.** Procédé selon la revendication 1 ou 2, dans lequel l'étape d) introduit des modifications sous la surface (40) du premier film diélectrique (4) ; le procédé comportant une étape $d_0$) consistant à traiter le premier film diélectrique (4) de manière à corriger lesdites modifications, l'étape $d_0$) étant exécutée après l'étape d) et avant l'étape e).

**4.** Procédé selon la revendication 3, dans lequel l'étape $d_0$) est exécutée en appliquant un rayonnement ultraviolet à la surface (40) du premier film diélectrique (4), sous une atmosphère d'ozone, à une température comprise entre 20°C et 500°C, préférentiellement comprise entre 20°C et 400°C, plus préférentiellement comprise entre 20°C et 300°C.

**5.** Procédé selon la revendication 1, comportant les étapes successives :

     - $d_1$) retirer le premier film diélectrique (4) après l'étape d) et avant l'étape e) ;
     - $d_2$) former un deuxième film diélectrique sur la première surface lissée (30') du substrat donneur (3), de sorte que le deuxième film diélectrique présente une surface conservant la topologie de surface reconstruite ;
     l'étape e) étant exécutée de sorte que l'adhésion directe s'opère avec la surface (40) du deuxième film diélectrique (4).

**6.** Procédé selon l'une des revendications 1 à 5, dans lequel l'étape b) est exécutée par un traitement thermique sous une atmosphère comportant des espèces hydrogénées, lorsque le substrat donneur (3)

est réalisé dans un matériau sélectionné parmi Si, Ge, Si$_x$Ge$_y$.

7. Procédé selon l'une des revendications 1 à 6, dans lequel l'étape c) est exécutée par une oxydation de la première surface (30) du substrat donneur (3) en appliquant un rayonnement ultraviolet, sous une atmosphère d'ozone, à une température comprise entre 20°C et 500°C, préférentiellement comprise entre 20°C et 400°C, plus préférentiellement comprise entre 20°C et 300°C.

8. Procédé selon l'une des revendications 1 à 6, dans lequel l'étape c) est exécutée par un dépôt ALD du premier film diélectrique (4).

9. Procédé selon l'une des revendications 1 à 8, comportant une étape consistant à lisser une première surface (20) du substrat support (2) jusqu'à l'obtention d'une topologie de surface reconstruite comprenant une succession de plans atomiques présentant une orientation cristalline principale ($\vec{o}$) formant un angle ($\alpha$) de désorientation inférieur à 5° avec la normale ($\vec{n}$) à la surface moyenne (S$_{moy}$) ; l'étape e) étant exécutée de sorte que l'adhésion directe s'opère avec la première surface (20) lissée du substrat support (2).

10. Procédé selon l'une des revendications 1 à 8, comportant les étapes :

- lisser une première surface (20) du substrat support (2) jusqu'à l'obtention d'une topologie de surface reconstruite comprenant une succession de plans atomiques présentant une orientation cristalline principale ($\vec{o}$) formant un angle ($\alpha$) de désorientation inférieur à 5° avec la normale ($\vec{n}$) à la surface moyenne (S$_{moy}$) ;
- former un film diélectrique additionnel (5) sur la première surface (20) lissée du substrat support (2), de sorte que le film diélectrique additionnel (5) présente une surface (50) conservant la topologie de surface reconstruite ; l'étape e) étant exécutée de sorte que l'adhésion directe s'opère avec la surface (50) du film diélectrique additionnel (5).

11. Procédé selon la revendication 10, dans lequel le premier film diélectrique (4) et le film diélectrique additionnel (5) présentent une épaisseur totale inférieure ou égale à 30 nm, préférentiellement inférieure ou égale à 20 nm, plus préférentiellement inférieure ou égale à 10 nm.

12. Procédé selon l'une des revendications 1 à 11, dans lequel le premier film diélectrique (4) formé lors de l'étape c) présente une épaisseur comprise entre 0,2 nm et 5 nm ou comprise entre 0,5 nm et 5 nm.

13. Procédé selon l'une des revendications 1 à 12, dans lequel le substrat donneur (3) est réalisé dans un matériau semi-conducteur, de préférence sélectionné dans le groupe comportant Si, Ge, Si-Ge, un matériau III-V.

14. Procédé selon l'une des revendications 1 à 13, comportant une étape e$_1$) consistant à appliquer un traitement thermique à l'assemblage obtenu lors de l'étape e) selon un budget thermique adapté pour renforcer l'adhésion directe sans initier la fracture du substrat donneur (3) suivant la zone de fragilisation (ZS) ; l'étape e$_1$) étant exécutée avant l'étape f).

**Patentansprüche**

1. Verfahren zur Übertragung einer Nutzschicht (1) auf ein Trägersubstrat (2), welches die aufeinander folgenden Schritte umfasst:

a) Bereitstellen eines Gebersubstrats (3), das eine erste Oberfläche (30) aufweist;
b) Glätten der ersten Oberfläche (30) des Gebersubstrats (3) bis zur Erzielung einer rekonstruierten Oberflächentopologie, die eine Folge von atomaren Ebenen umfasst, die eine hauptsächliche Kristallausrichtung ($\vec{o}$) aufweisen, die einen Fehlausrichtungswinkel ($\alpha$) von weniger als 5° mit der Normalen ($\vec{n}$) zur mittleren Oberfläche (S$_{moy}$) bildet;
c) Ausbilden eines ersten dielektrischen Films (4) auf der geglätteten ersten Oberfläche (30') des Gebersubstrats (3), so dass der erste dielektrische Film (4) eine Oberfläche (40) aufweist, welche die rekonstruierte Oberflächentopologie beibehält;
d) Implantieren gasförmiger Spezies in das Gebersubstrat (3) durch den ersten dielektrischen Film (4) hindurch, um so einen Versprödungsbereich (ZS) zu bilden, wobei die Nutzschicht (1) von dem Versprödungsbereich (ZS) und von der ersten Oberfläche (30) des Gebersubstrats (3) begrenzt wird;
e) Zusammenfügen des Gebersubstrats (3) mit dem Trägersubstrat (2) durch eine direkte Haftung;
f) Brechen des Gebersubstrats (3) entlang des Versprödungsbereichs (ZS), um so die Nutzschicht (1) freizulegen.

2. Verfahren nach Anspruch 1, wobei der Schritt e) derart ausgeführt wird, dass die direkte Haftung mit der Oberfläche (40) des ersten dielektrischen Films (4) erfolgt.

**3.** Verfahren nach Anspruch 1 oder 2, wobei der Schritt d) Veränderungen unter der Oberfläche (40) des ersten dielektrischen Films (4) hervorruft; wobei das Verfahren einen Schritt $d_0$) umfasst, der darin besteht, den ersten dielektrischen Film (4) so zu behandeln, dass diese Veränderungen korrigiert werden, wobei der Schritt $d_0$) nach dem Schritt d) und vor dem Schritt e) ausgeführt wird.

**4.** Verfahren nach Anspruch 3, wobei der Schritt $d_0$) ausgeführt wird, indem die Oberfläche (40) des ersten dielektrischen Films (4) einer ultravioletten Strahlung unter einer Ozonatmosphäre bei einer Temperatur zwischen 20 °C und 500 °C, vorzugsweise zwischen 20 °C und 400 °C, stärker bevorzugt zwischen 20 °C und 300 ° ausgesetzt wird.

**5.** Verfahren nach Anspruch 1, welches die aufeinander folgenden Schritte umfasst:

- $d_1$) Entfernen des ersten dielektrischen Films (4) nach dem Schritt d) und vor dem Schritt e);
- $d_2$) Ausbilden eines zweiten dielektrischen Films auf der geglätteten ersten Oberfläche (30') des Gebersubstrats (3), so dass der zweite dielektrische Film eine Oberfläche aufweist, welche die rekonstruierte Oberflächentopologie beibehält;
wobei der Schritt e) derart ausgeführt wird, dass die direkte Haftung mit der Oberfläche (40) des zweiten dielektrischen Films (4) erfolgt.

**6.** Verfahren nach einem der Ansprüche 1 bis 5, wobei der Schritt b) durch eine Wärmebehandlung unter einer Atmosphäre ausgeführt wird, welche hydrierte Spezies aufweist, wenn das Gebersubstrat (3) aus einem Material hergestellt ist, das aus Si, Ge, $Si_xGe_y$ ausgewählt ist.

**7.** Verfahren nach einem der Ansprüche 1 bis 6, wobei der Schritt c) durch eine Oxidation der ersten Oberfläche (30) des Gebersubstrats (3) ausgeführt wird, indem diese einer ultravioletten Strahlung unter einer Ozonatmosphäre bei einer Temperatur zwischen 20 °C und 500 °C, vorzugsweise zwischen 20 °C und 400 °C, stärker bevorzugt zwischen 20 °C und 300 °C ausgesetzt wird.

**8.** Verfahren nach einem der Ansprüche 1 bis 6, wobei der Schritt c) durch eine Atomlagenabscheidung des ersten dielektrischen Films (4) ausgeführt wird.

**9.** Verfahren nach einem der Ansprüche 1 bis 8, welches einen Schritt umfasst, der darin besteht, eine erste Oberfläche (20) des Trägersubstrats (2) bis zur Erzielung einer rekonstruierten Oberflächentopologie zu glätten, die eine Folge von atomaren Ebenen umfasst, die eine hauptsächliche Kristallausrichtung $(\vec{o})$ aufweisen, die einen Fehlausrichtungswinkel ($\alpha$) von weniger als 5° mit der Normalen $(\vec{n})$ zur mittleren Oberfläche ($S_{moy}$) bildet; wobei der Schritt e) derart ausgeführt wird, dass die direkte Haftung mit der geglätteten ersten Oberfläche (20) des Trägersubstrats (2) erfolgt.

**10.** Verfahren nach einem der Ansprüche 1 bis 8, welches die Schritte umfasst:

- Glätten einer ersten Oberfläche (20) des Trägersubstrats (2) bis zur Erzielung einer rekonstruierten Oberflächentopologie, die eine Folge von atomaren Ebenen umfasst, die eine hauptsächliche Kristallausrichtung $(\vec{o})$ aufweisen, die einen Fehlausrichtungswinkel ($\alpha$) von weniger als 5° mit der Normalen $(\vec{n})$ zur mittleren Oberfläche ($S_{moy}$) bildet;
- Ausbilden eines zusätzlichen dielektrischen Films (5) auf der geglätteten ersten Oberfläche (20) des Trägersubstrats (2), so dass der zusätzliche dielektrische Film (5) eine Oberfläche (50) aufweist, welche die rekonstruierte Oberflächentopologie beibehält;
wobei der Schritt e) derart ausgeführt wird, dass die direkte Haftung mit der Oberfläche (50) des zusätzlichen dielektrischen Films (5) erfolgt.

**11.** Verfahren nach Anspruch 10, wobei der erste dielektrische Film (4) und der zusätzliche dielektrische Film (5) eine Gesamtdicke aufweisen, die kleiner oder gleich 30 nm, vorzugsweise kleiner oder gleich 20 nm, stärker bevorzugt kleiner oder gleich 10 nm ist.

**12.** Verfahren nach einem der Ansprüche 1 bis 11, wobei der im Schritt c) ausgebildete erste dielektrische Film (4) eine Dicke zwischen 0,2 nm und 5 nm oder zwischen 0,5 nm und 5 nm aufweist.

**13.** Verfahren nach einem der Ansprüche 1 bis 12, wobei das Gebersubstrat (3) aus einem Halbleitermaterial hergestellt ist, das vorzugsweise aus der Gruppe ausgewählt ist, welche Si, Ge, Si-Ge und einen III-IV-Verbindungshalbleiter umfasst.

**14.** Verfahren nach einem der Ansprüche 1 bis 13, welches einen Schritt $e_1$) umfasst, der darin besteht, auf den im Schritt e) erhaltenen Verbund eine Wärmebehandlung mit einem angepassten Wärmehaushalt anzuwenden, um die direkte Haftung zu verstärken, ohne das Brechen des Gebersubstrats (3) entlang des Versprödungsbereichs (ZS) auszulösen; wobei der Schritt $e_1$) vor dem Schritt f) ausgeführt wird.

## Claims

1. Method for transferring a useful layer (1) to a carrier substrate (2), including the successive steps of:

   a) providing a donor substrate (3) comprising a first surface (30);
   b) smoothing the first surface (30) of the donor substrate (3) until a reconstructed surface topology comprising a succession of atomic planes having a principal crystal orientation $(\vec{o})$ forming an angle $(\alpha)$ of disorientation of less than 5° with the normal $(\vec{n})$ to the middle surface $(S_{moy})$ is obtained;
   c) forming a first dielectric film (4) on the smoothed first surface (30') of the donor substrate (3), in such a way that the first dielectric film (4) has a surface (40) that preserves the reconstructed surface topology;
   d) implanting gaseous species into the donor substrate (3), through the first dielectric film (4), so as to form a weakened zone (ZS), the useful layer (1) being delimited by the weakened zone (ZS) and by the first surface (30) of the donor substrate (3);
   e) joining the donor substrate (3) to the carrier substrate (2) by direct bonding;
   f) splitting the donor substrate (3) along the weakened zone (ZS) so as to expose the useful layer (1).

2. Method according to Claim 1, wherein step e) is carried out in such a way that direct bonding takes place with the surface (40) of the first dielectric film (4).

3. Method according to Claim 1 or 2, wherein step d) introduces changes under the surface (40) of the first dielectric film (4); the method including a step $d_0$) of treating the first dielectric film (4) so as to correct said changes, step $d_0$) being carried out after step d) and before step e).

4. Method according to Claim 3, wherein step $d_0$) is carried out by applying ultraviolet radiation to the surface (40) of the first dielectric film (4), under an ozone atmosphere, at a temperature of between 20°C and 500°C, preferably between 20°C and 400°C, more preferably between 20°C and 300°C.

5. Method according to Claim 1, including the successive steps of:

   - $d_1$) removing the first dielectric film (4) after step d) and before step e);
   - $d_2$) forming a second dielectric film on the smoothed first surface (30') of the donor substrate (3), so that the second dielectric film has a surface that preserves the reconstructed surface topology;
   step e) being carried out in such a way that direct bonding takes place with the surface (40) of the second dielectric film (4).

6. Method according to one of Claims 1 to 5, wherein step b) is carried out by heat treatment under an atmosphere comprising hydrogenated species, when the donor substrate (3) is made of a material selected from Si, Ge and $Si_xGe_y$.

7. Method according to one of Claims 1 to 6, wherein step c) is carried out by oxidation of the first surface (30) of the donor substrate (3) by applying ultraviolet radiation, under an ozone atmosphere, at a temperature of between 20°C and 500°C, preferably between 20°C and 400°C, more preferably between 20°C and 300°C.

8. Method according to one of Claims 1 to 6, wherein step c) is carried out by depositing the first dielectric film (4) by ALD.

9. Method according to one of Claims 1 to 8, including a step of smoothing a first surface (20) of the carrier substrate (2) until a reconstructed surface topology comprising a succession of atomic planes having a principal crystal orientation $(\vec{o})$ forming an angle $(\alpha)$ of disorientation of less than 5° with the normal $(\vec{n})$ to the middle surface $(S_{moy})$ is obtained; step e) being carried out in such a way that direct bonding takes place with the smoothed first surface (20) of the carrier substrate (2).

10. Method according to one of Claims 1 to 8, including the steps of:

    - smoothing a first surface (20) of the carrier substrate (2) until a reconstructed surface topology comprising a succession of atomic planes having a principal crystal orientation $(\vec{o})$ forming an angle $(\alpha)$ of disorientation of less than 5° with the normal $(\vec{n})$ to the middle surface $(S_{moy})$ is obtained;
    - forming an additional dielectric film (5) on the smoothed first surface (20) of the carrier substrate (2), so that the additional dielectric film (5) has a surface (50) that preserves the reconstructed surface topology;
    step e) being carried out in such a way that direct bonding takes place with the surface (50) of the additional dielectric film (5).

11. Method according to Claim 10, wherein the first dielectric film (4) and the additional dielectric film (5) have a total thickness of less than or equal to 30 nm, preferably less than or equal to 20 nm, more preferably less than or equal to 10 nm.

12. Method according to one of Claims 1 to 11, wherein the first dielectric film (4) formed in step c) has a thickness of between 0.2 nm and 5 nm or between 0.5 nm and 5 nm.

13. Method according to one of Claims 1 to 12, wherein the donor substrate (3) is made of a semiconductor material, preferably selected from the group comprising Si, Ge, Si-Ge and a III-V material.

14. Method according to one of Claims 1 to 13, including a step $e_1$) of applying a heat treatment to the assembly obtained in step e) according to a suitable thermal budget for reinforcing the direct bonding without initiating the splitting of the donor substrate (3) along the weakened zone (ZS); step $e_1$) being carried out before step f).

*Fig. 1a*

*Fig. 1b*

*Fig. 1c*

*Fig. 1d*

*Fig. 1e*

*Fig. 1f*

*Fig. 2a*

*Fig. 2b*

*Fig. 2d*

*Fig. 2c*

*Fig. 2e*

*Fig. 2f*

*Fig. 2g*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011086492 A

**Littérature non-brevet citée dans la description**

- **M. KOLMER et al.** Atomic scale fabrication of dangling bond structures on hydrogen passivated Si (0 0 1) wafers processed and nanopackaged in a clean room environment. *Appl. Surf. Sci.,* 2014, vol. 288, 83-89

- **V. LOUP et al.** Reduced pressure chemical vapour deposition of Si/Si1-x-yGexCy heterostructures using a chlorinated chemistry. *Semicond. Sci. Technol.,* 2003, vol. 18, 352-360